# EUROPÄISCHE PATENTANMELDUNG

(11) **EP 2 023 700 A2**
(43) Veröffentlichungstag der Anmeldung: **11.02.2009**
(21) Anmeldenummer: 08104640.1
(22) Anmeldetag: 04.07.2008
(51) Int. Cl.: H05K 3/20

(54) **Elektrische Schaltung sowie Verfahren zur Herstellung einer elektrischen Schaltung**

(30) Priorität: 08.08.2007 DE 102007037366
(71) Anmelder: ROBERT BOSCH GMBH, 70442 Stuttgart (DE)
(72) Erfinder: Kimmich, Peter, 71101, Schoenaich (DE); Keil, Stefan, 72072, Tuebingen (DE); Ruf, Christoph, 72800, Eningen (DE); Keil, Matthias, 72760, Reutlingen (DE); Koelle, Gerhard, 75446, Wiernsheim (DE); Kalich, Thomas, 72805, Lichtenstein (DE)

(57) **Zusammenfassung**

Die Erfindung betrifft eine elektrische Schaltung, insbesondere Leistungselektronik-Schaltung, mit einem Schaltungsträger und mit mindestens einem darauf angeordneten Stanzgitter. Es ist vorgesehen, dass das Stanzgitter (4) zu seinem Auftrennen mindestens eine Trennstelle (7) und der Schaltungsträger (3) mindestens eine der Trennstelle (7) zugeordnete Ausnehmung (8) zur Aufnahme und/oder zum Untergreifen mindestens eines Trennstellenabschnitts (10,20,21) des Stanzgitters (4) aufweist.

Weiter betrifft die Erfindung ein Verfahren zur Herstellung einer elektrischen Schaltung mit folgenden Schritten:
- Erstellen eines Schaltungsträgers mit mindestens einer Ausnehmung,
- Anordnen eines Stanzgitters auf dem Schaltungsträger,
- Erstellen mindestens einer Trennstelle in dem Stanzgitter im Bereich der Ausnehmung und
- Untergreifen mindestens eines Trennstellenabschnitts und/oder Einbringen des mindestens einen Trennstellenabschnitts in die Ausnehmung.

## Beschreibung

Die Erfindung betrifft eine elektrische Schaltung, insbesondere eine Leistungselektronik-Schaltung, mit einem Schaltungsträger und mit mindestens einem darauf angeordneten Stanzgitter.

Ferner betrifft die Erfindung ein Verfahren zur Herstellung einer elektrischen Schaltung, insbesondere einer Leistungselektronik-Schaltung.

### Stand der Technik

Elektrische Schaltungen sowie Verfahren der eingangs genannten Art sind bekannt. Aus thermischen und finanziellen Gründen werden dabei, insbesondere bei Leistungselektronik-Schaltungen, zur elektrischen Verbindung häufig Stanzgitter verwendet, die direkt auf einem Schaltungsträger angeordnet werden. Ein Stanzgitter ist ein durch Stanzen erzeugtes, meist zweidimensionales elektrisch leitfähiges Netzwerk. In nur einem Fertigungsschritt (Stanzen) werden dabei mehrere elektrisch leitfähige Leiterbahnen, beispielsweise in Form von Metallstreifen, erstellt, die zur einfachen Handhabung zunächst miteinander, beispielsweise über Verbindungsstege, verbunden sind, sodass das Stanzgitter als ein Bauelement gehandhabt werden kann. Um die unterschiedlichen/einzelnen Leiterbahnen verwenden zu können, muss das Stanzgitter vor Inbetriebnahme der Schaltung vereinzelt beziehungsweise aufgetrennt werden.

### Offenbarung der Erfindung

Die Erfindung sieht vor, dass das Stanzgitter zu seinem Auftrennen mindestens eine Trennstelle und der Schaltungsträger mindestens eine der Trennstelle zugeordnete Aufnehmung zur Aufnahme oder zum Untergreifen mindestens eines Trennstellenabschnittes des Stanzgitters aufweist. Es ist also vorgesehen, dass das Stanzgitter mindestens eine Trennstelle zum Auftrennen aufweist. Weiterhin ist vorgesehen, dass der Schaltungsträger mindestens eine dieser Trennstelle zugeordnete Ausnehmung aufweist. Mit anderen Worten befindet sich die Trennstelle des auf dem Schaltungsträger angeordneten Stanzgitters im Bereich der Ausnehmung des Schaltungsträgers. Wobei die Ausnehmung zur Aufnahme oder zum Untergreifen mindestens eines Trennstellenabschnittes des Stanzgitters ausgebildet ist. Die Ausnehmung ist hierbei also so angeordnet und/oder ausgebildet, dass ein Trennstellenabschnitt des Stanzgitters, also ein zur Trennstelle benachbarter und/oder diese aufweisender Abschnitt des Stanzgitters, von der Ausnehmung aufgenommen werden kann, oder sodass der Trennstellenabschnitt des Stanzgitters untergriffen werden kann. Hierdurch ist es möglich, das Stanzgitter nach dem Anordnen auf dem Schaltungsträger in einzelne Stanzgitter-Strukturen beziehungsweise Stanzgitter-Leiterbahnen zu vereinzeln beziehungsweise aufzutrennen. Dabei kann der Trennstellenabschnitt mittels eines geeigneten Werkzeuges in die Ausnehmung eingebracht beziehungsweise eingedrückt werden, wobei die Trennstelle aufgetrennt wird. Weiterhin ist es möglich mit einem geeigneten Werkzeug den Trennstellenabschnitt zu untergreifen, das heißt mit einem Werkzeug in die Ausnehmung "einzutauchen" und von "hinten" das Stanzgitter an der Trennstelle aufzutrennen. Durch die vorteilhafte Ausbildung wird die Montage der elektrischen Schaltung vereinfacht, da das Stanzgitter nicht vor dem Anordnen auf dem Schaltungsträger vereinzelt beziehungsweise aufgetrennt werden muss. Das Auftrennen erfolgt durch die vorteilhafte Ausbildung nach dem Aufbringen des Stanzgitters auf den Schaltungsträger, sodass das Stanzgitter vorher als ein Teil auf einfache Art und Weise gehandhabt und auf den Schaltungsträger aufgebracht werden kann. Der Trennstellenabschnitt wird entweder vollständig oder nur teilweise, beispielsweise einseitig, von dem Stanzgitter gelöst beziehungsweise auftetrennt.

Zweckmäßigerweise ist die Ausnehmung als Aufnahmetasche oder als Durchbruch ausgebildet. Wird der Trennstellenabschnitt des Stanzgitters bei dem Auftrennvorgang nicht vollständig von dem Stanzgitter gelöst, so kann er beispielsweise in die Aufnahmetasche des Schaltungsträgers eingedrückt werden und kann dabei als zusätzliches Befestigungsmittel für das Stanzgitter dienen. Darüber hinaus wird verhindert, dass ein von dem Stanzgitter vollständig abgetrennter Trennstellenabschnitt als loser "Flitter" in einem die elektrische Schaltung aufweisenden Gehäuse zu Beschädigungen, beispielsweise durch Erzeugen eines Kurzschlusses, führt. Durch das Ausbilden der Ausnehmung als Durchbruch kann der Trennstellenabschnitt, sofern er vollständig von dem Stanzgitter getrennt ist/wurde, durch den Schaltungsträger hindurch fallen und/oder gedrückt werden, sodass er auf der anderen Seite heraus fällt und entsorgt/entfernt werden kann.

Nach einer Weiterbildung der Erfindung ist die Trennstelle als Sollbruchstelle, insbesondere als Stanz- und/oder Schneidstelle ausgebildet. Durch Vorsehen einer Sollbruchstelle wird der Schneid- und/oder Stanzprozess zum Auftrennen der Trennstelle des Stanzgitters erleichtert. Eine derartige Sollbruchstelle kann beispielsweise durch Vorkerbung, Ansägen, Anschneiden, eine Verjüngung oder Ähnlichem gebildet sein. Es ist auch denkbar, die Trennstelle des Stanzgitters aus mehreren dünnen einzelnen Verbindungsstegen zu bilden, die nacheinander oder gleichzeitig aufgetrennt werden. Wobei vorteilhafterweise der die Sollbruchstelle bildende Abschnitt der Trennstelle, beispielsweise die einzelnen dünnen Verbindungsstege, - in Draufsicht gesehen - innerhalb der Ausnehmung liegt und nicht bis zum Rand der Ausnehmung reicht. Durch beim Trennvorgang auftretenden Biegekräfte werden die dünnen Stege in die Ausnehmung gebogen, ohne dass sie den Schaltungsträger selbst beziehungsweise den Rand der Ausnehmung berühren. Hierdurch wird beispielsweise verhindert, dass eine unerwünschte elektrische Verbindung zwischen dem Stanzgitter und dem Schaltungsträger entsteht.

Weiter ist vorgesehen, dass das Stanzgitter mittels Klebstoff und/oder mittels mindestens einer Klebstofffolie auf dem Schaltungsträger befestigt ist. Durch das Anbringen des Stanzgitters auf dem Schaltungsträger mittels einer Klebstofffolie ergibt sich der Vorteil, dass von dem Stanzgitter vollständig gelöste Trennstellenabschnitte an der Klebstofffolie haften bleiben und somit nicht als Flitter zu einem Kurzschluss führen können. Vorteilhafterweise weist die Klebstofffolie eine gute Wärmeleitfähigkeit auf, um erzeugte Wärme über das Stanzgitter auf den Schaltungsträger (oder anders herum) abführen zu können.

Bevorzugt weist die Klebstofffolie und/oder der Klebstoff mindestens eine Isolationsschicht auf, um einen elektrischen Kontakt zwischen Stanzgitter und Schaltungsträger zu verhindern. Zusätzlich oder alternativ ist es denkbar, die Ausnehmung des Schaltungsträgers mit einer isolierenden Schicht zu versehen. Beispielsweise kann in die als Durchbruch ausgebildete Ausnehmung eine Kunststoffhülse eingebracht werden, die verhindert, dass ein in die Ausnehmung gebogener Trennabschnitt des Stanzgitters mit dem Schaltungsträger in direkten (elektrischen) Kontakt kommt.

Vorteilhafterweise ist auf der dem Stanzgitter gegenüberliegenden Seite des Schaltungsträgers mindestens ein Auffangmittel, insbesondere eine Auffangfolie angeordnet. Wird der Trennstellenabschnitt des Stanzgitters vollständig von dem Stanzgitter getrennt, so fällt er auf die Auffangfolie und kann so nach dem Trennvorgang auf einfache Art und Weise entfernt werden. Die Auffangfolie kann beispielsweise zumindest eine klebende Oberfläche aufweisen, sodass der Trennstellenabschnitt daran haften bleibt. Darüber hinaus kann dadurch die Auffangfolie auf die Rückseite des Schaltungsträgers geklebt werden. Ebenfalls ist es denkbar, die Auffangfolie auf eine unter dem Schaltungsträger liegenden Stützplatte anzuordnen.

Schließlich ist vorgesehen, dass das Stanzgitter mit mindestens einem elektrischen/elektronischen Bauteil, insbesondere Leistungsbauteil bestückt ist. Das Bauteil kann dabei vor oder nach dem Auftrennvorgang auf das Stanzgitter aufgebracht werden. Auch kann das Stanzgitter bereits vor dem Aufkleben mit dem Bauteil bestückt sein. Vorteilhafterweise ist der Schaltungsträger als Aluminium-Grundplatte ausgebildet.

Das erfindungsgemäße Verfahren zur Herstellung einer elektrischen Schaltung, insbesondere einer wie oben stehend beschriebenen elektrischen Schaltung, insbesondere Leistungsschaltung, sieht vor, dass zunächst ein Schaltungsträger mit mindestens einer Ausnehmung erstellt wird, anschließend wird ein Stanzgitter auf dem Schaltungsträger angeordnet, wobei mindestens eine Trennstelle in dem Stanzgitter im Bereich der Ausnehmung erstellt wird und ein Trennstellenabschnitt der Trennstelle untergriffen und/oder in die Ausnehmung eingebracht wird. Durch die Ausnehmung in dem Schaltungsträger wird ermöglicht, das Stanzgitter nach dem Anordnen auf dem Schaltungsträger in einzelne Stanzgitter-Strukturen beziehungsweise -Leiterbahnen aufzuteilen/aufzutrennen. Dazu wird die Trennstelle vorteilhafterweise durch Stanzen und/oder Schneiden aufgetrennt. Der Trennstellenabschnitt wird dabei entweder vollständig oder teilweise in die Ausnehmung eingebracht. Wird der Trennstellenabschnitt nur einseitig von dem Stanzgitter getrennt, so wird der verbleibende Teil in die Ausnehmung eingebogen. Wird der Trennstellenabschnitt vollständig von dem Stanzgitter gelöst, so wird der ausgestanzte/ausgeschnittene Trennstellenabschnitt vollständig in die Ausnehmung eingebracht. Durch ein Untergreifen des Trennstellenabschnittes kann der Trennstellenabschnitt "von hinten" von dem Stanzgitter zumindest teilweise (einseitig) gelöst werden. Beispielsweise kann eine entsprechende Schneide den Trennstellenabschnitt untergreifen und beim Herausziehen die Trennstelle auftrennen und dabei den Trennstellenabschnitt nach außen biegen, sodass ein elektrischer Kontakt auch dauerhaft verhindert wird.

Zweckmäßigerweise wird die Ausnehmung als Aufnahmetasche oder als Durchbruch ausgebildet. Ist ein Untergreifen des Trennstellenabschnittes vorgesehen, so wird die Ausnehmung vorteilhafterweise seitlich etwas breiter als das Stangitter ausgebildet, sodass ein entsprechendes Trenn-Werkzeug an dem Stanzgitter vorbei unter das Stanzgitter beziehungsweise den Trennstellenabschnitt des Stanzgitters greifen kann.

Vorteilhafterweise wird das Stanzgitter mit einem Klebstoff und/oder einer Klebstofffolie auf dem Schaltungsträger befestigt. Wobei die Klebstofffolie und/oder der Klebstoff bevorzugt mit einer Isolationsschicht versehen wird.

Nach einer Weiterbildung der Erfindung wird das Stanzgitter mit mindestens einem elektrischen/elektronischen Bauteil, insbesondere Leistungsbauteil, vor oder nach dem Auftrennen des Stanzgitters beziehungsweise der Trennstelle bestückt.

Schließlich ist vorgesehen, dass auf der dem Stanzgitter gegenüberliegenden Seite des Schaltungsträgers ein Auffangmittel, insbesondere eine Auffangfolie, angeordnet wird.

### Kurze Beschreibung der Zeichnungen

Im Folgenden soll die Erfindung anhand einiger Figuren näher erläutert werden. Dazu zeigen
- Figur 1: ein erstes Ausführungsbeispiel einer vorteilhaften elektrischen Schaltung,
- Figur 2: ein zweites Ausführungsbeispiel der vorteilhaften Schaltung,
- Figur 3: ein drittes Ausführungsbeispiel der vorteilhaften Schaltung,
- Figur 4: ein viertes Ausführungsbeispiel der vorteilhaften Schaltung,
- Figur 5: ein fünftes Ausführungsbeispiel der vorteilhaften Schaltung und
- Figur 6: ein sechstes Ausführungsbeispiel der vorteilhaften Schaltung.

### Ausführungsform(en) der Erfindung

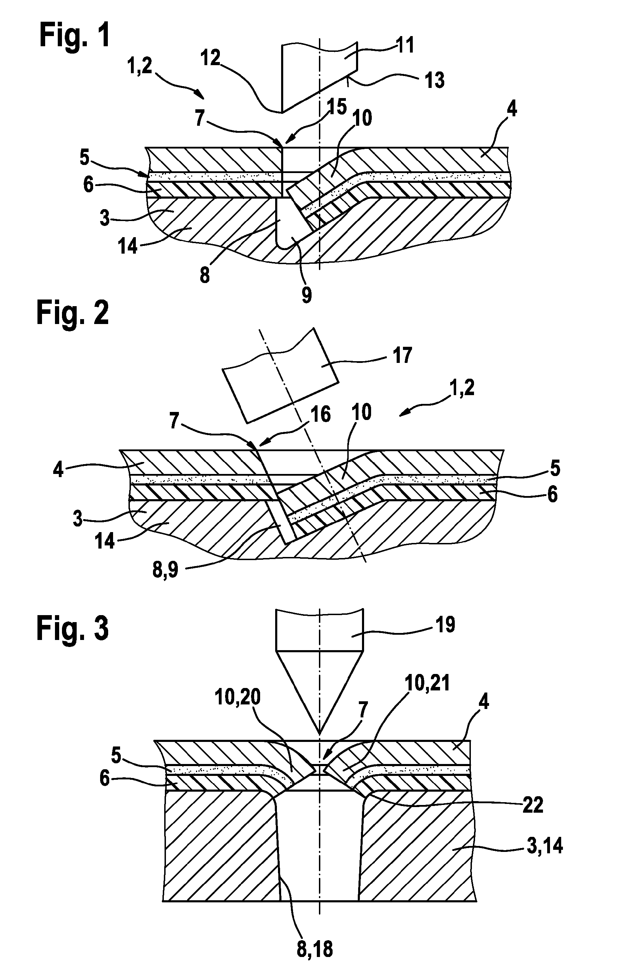

Die Figur 1 zeigt in einer Schnittdarstellung ein erstes Ausführungsbeispiel einer vorteilhaften elektrischen Schaltung 1, die als Leistungselektronik 2 ausgebildet ist. Die Schaltung 1 weist einen Schaltungsträger 3 sowie ein darauf angeordnetes Stanzgitter 4 auf. Zwischen dem Stanzgitter 4 und dem Schaltungsträger 3 ist eine isolierende Schicht angeordnet, die vorteilhafterweise eine Klebstofffolie 5 und eine Isolationsschicht 6 aufweist, welche auf dem Schaltungsträger 3 aufliegt. Natürlich ist es auch denkbar, mehrere isolierende Schichten vorzusehen. Das Stanzgitter 4 weist weiterhin eine Trennstelle 7 auf, an der das Stanzgitter 4 aufgetrennt werden soll. Der Trennstelle 7 ist einer Ausnehmung 8 des Schaltungsträgers 3 zugeordnet. Die Ausnehmung 8 ist hierbei als - im Schnitt gesehen - etwa dreieckförmige Aufnahmetasche 9 ausgebildet. Die Ausnehmung 8 dient hierbei zur Aufnahme eines Trennstellenabschnittes 10 des Stanzgitters 4. Aus Handhabbarkeitsgründen ist das Stanzgitter 4 vor dem Aufbringen auf dem Schaltungsträger 3 nicht an der Trennstelle 7 aufgetrennt, sodass beispielsweise einzelne Leiterbahnen vor dem Aufbringen auf dem Schaltungsträger 3 noch miteinander verbunden sind. Die in der Figur 1 dargestellte Schaltung 1 erlaubt auf einfache Art und Weise ein Auftrennen des Stanzgitters 4 nachdem es auf dem Schaltungsträger 3 angeordnet worden ist. In dem in der Figur 1 ausgeführten Ausführungsbeispiel wird dazu mittels eines Schneidwerkzeuges 11 der Trennstellenabschnitt 10 in die Aufnahmetasche 9 beziehungsweise Ausnehmung 8 eingebracht. Das Schneidwerkzeug 11 wird dabei bevorzugt senkrecht zu dem Stanzgitter 4 bewegt und weist eine von der Schneidkante 12 ausgehend schräg verlaufende Oberfläche 13 auf, die beim Schneidvorgang den Trennstellenabschnitt 10 umbiegt, sodass er in die Ausnehmung 8 eingebracht wird. Die Klebstofffolie 5 mit der Isolationsschicht 6 wird dabei mitsamt den Trennstellenabschnitt 10 in die Ausnehmung 8 beziehungsweise die Aufnahmetasche 9 eingebracht, und vorteilhafterweise gegen die Innenwand der Aufnahmetasche 9 gedrückt. Vorteilhafterweise ist das Stanzgitter 4 als Kupferstanzgitter und der Schaltungsträger 3 als Aluminiumgrundplatte 14 ausgebildet, sodass das System eine vorteilhafte Wärmeleitfähigkeit aufweist. Auch die Klebstofffolie 5 sowie die Isolationsschicht 6 weisen eine gute Wärmeleitfähigkeit auf. Der Schaltungsträger 3 beziehungsweise die Aluminiumgrundplatte 14 kann dabei beispielsweise von einem Kühlkörper gebildet werden. Ist das Stanzgitter 4 an mehreren Stellen aufzutrennen, so können diese entweder nacheinander oder auch gleichzeitig mit einem entsprechenden Auftrennwerkzeug, wie oben beschrieben, aufgetrennt werden.

Die Figur 2 zeigt ein zweites Ausführungsbeispiel der vorteilhaften Schaltung 1, das im Wesentlichen dem in der Figur 1 dargestellten Ausführungsbeispiel entspricht. Aus der Figur 1 bekannte Elemente werden sowohl hier als auch in den folgenden Figuren mit den gleichen Bezugszeichen versehen. Im Unterschied zu der in der Figur 1 dargestellten Trennstelle 7, die als Schneidstelle 15 ausgebildet ist, ist in der Figur 2 die Trennstelle 7 als eine Stanzstelle 16 ausgebildet. Der wesentliche Unterschied besteht darin, dass anstelle des Schneidwerkzeugs 11 ein Stanzwerkzeug 17 schräg geführt ist, und somit das Stanzgitter an der Stanzstelle 16 auftrennt und den Trennstellenabschnitt 10 in die Ausnehmung 8 einbringt. Vorteilhafterweise ist die Isolationsschicht 6 klebend ausgebildet, sodass der Trennstellenabschnitt 10 auf der Oberfläche der Innenwand der Aufnahmetasche 9 kleben bleibt. Wird der Trennstellenabschnitt 10 vollständig von dem Stanzgitter 4 gelöst, so wird er durch Andrücken auf den Schaltungsträger 3 "geklebt", sodass er nicht als frei beweglicher Flitter zu Kurzschlüssen führen kann.

Die Figur 3 zeigt in einer Schnittdarstellung ein weiteres Ausführungsbeispiel einer vorteilhaften Schaltung 1. Hierbei ist die Ausnehmung 8 als Durchbruch 18 ausgebildet. Zum Auftrennen der Trennstelle 7 wird ein spitzes Schneidwerkzeug 19 senkrecht zu dem Stanzgitter 4 beziehungsweise dem Schaltungsträger 3 geführt, sodass ein erster Trennstellenabschnitt 20 und ein zweiter Trennstellenabschnitt 21, die zusammen den Trennstellenabschnitt 10 bilden, in die Ausnehmung 8 beim Auftrennen eingebracht werden. Um zu verhindern, dass ein Rand der Ausnehmung 8 durch die Isolationsschicht und die Klebstoffschicht schneidet und dadurch einen elektrischen Kontakt zwischen dem Schaltungsträger 3 und dem Stanzgitter 4 zustande kommt, weist die Ausnehmung 8 beziehungsweise der Durchbruch 18 an seinem dem Stanzgitter 4 zugewandten Ende eine allumfängliche Abrundung 22 auf.

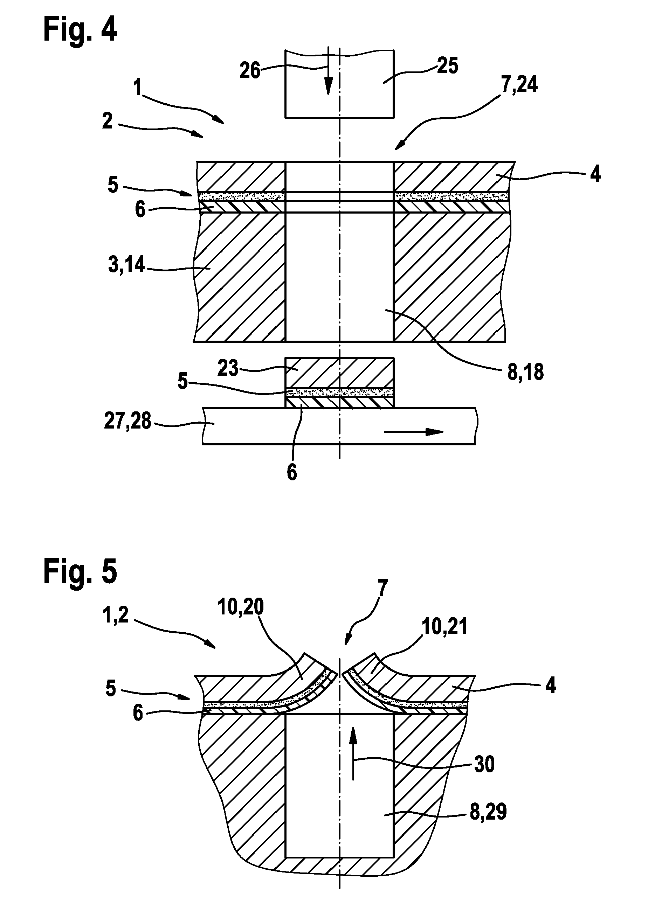

Die Figur 4 zeigt in einer Schnittdarstellung ein weiteres Ausführungsbeispiel der vorteilhaften elektrischen Schaltung 1, wobei hier die Ausnehmung 8 ebenfalls als Durchbruch 18 ausgebildet ist. Im Gegensatz zu den vorhergehenden Ausführungsbeispielen ist hier ein vollständiges Trennen eines Trennstellenabschnittes 23 von dem Stanzgitter 4 vorgesehen. Die Trennstelle 7 ist hierbei als Stanzstelle 24 ausgebildet, sodass der Trennstellenabschnitt 23 aus dem Stanzgitter 4 vollständig ausgestanzt wird. Dazu wird ein Stanzwerkzeug 25 senkrecht zur Oberfläche des Stanzgitters 4 in Richtung eines Pfeils 26 geführt, wobei der Umfang des Stanzwerkzeugs 25 im Wesentlichen der Kontur des Durchbruches 18 entspricht, sodass der beim Auftrennen des Stanzgitters 4 ausgestanzte Trennstellenabschnitt 23 durch den Durchbruch 18 hindurch von dem Stanzwerkzeug 25 gedrückt wird oder durch den Durchbruch 18 hindurch fallen kann. Dadurch wird der Trennstellenabschnitt 23 von der Schaltung 1 entfernt, sodass er beispielsweise nicht als Flitterelement zu Kurzschlüssen in der Schaltung 1 führt. Auf der dem Stanzgitter 4 gegenüberliegenden Seite des Schaltungsträgers 3 ist in dem vorliegenden Ausführungsbeispiel ein Auffangmittel 27, das als Auffangfolie 28 ausgebildet ist, angeordnet. Beim Auftrennen des Stanzgitters 4 gelangt der Trennstellenabschnitt 23 vorteilhafterweise auf das Auffangmittel 27, bleibt dort auf Grund der Klebstofffolie 5 haften und kann durch Entfernen des Auffangmittels 27 von der Schaltung 1 entfernt werden. Vorteilhafterweise weist das Auffangmittel 27 eine klebende Oberfläche auf, sodass der Trennstellenabschnitt 23 daran haften bleibt, auch wenn der Trennstellenabschnitt nicht mit einer Klebstofffolie/mit Klebstoff versehen ist, oder beispielsweise der Klebstoff bereits ausgehärtet ist. Natürlich kann das Auffangmittel 27 auch als Auffangplatte ausgebildet sein.

Die Figur 5 zeigt ein weiteres Ausführungsbeispiel der vorteilhaften Schaltung 1, das im Wesentlichen dem Ausführungsbeispiel der Figur 3 entspricht, mit dem Unterschied, dass die Ausnehmung 8 zum Untergreifen des Trennstellenabschnitts 10 beziehungsweise der Trennstellenabschnitte 20, 21 ausgebildet ist. Die als Sackloch 29 ausgebildete Ausnehmung 8 ist dabei derart breit ausgebildet, dass ein Werkzeug an dem Stanzgitter 4 vorbei in die Ausnehmung 8 geführt und das Stanzgitter 4 untergreifen kann. Durch eine Zieh-Schneidbewegung in Richtung des Pfeils 30 wird das Stanzgitter 4 anschließend aufgetrennt, wobei die Trennstellenabschnitte 20 und 21 voneinander weggebogen werden, sodass ein elektrischer Kontakt unterbrochen wird. Als Werkzeuge zum Auftrennen der Trennstelle 7 kann beispielsweise ein Vakuumsauger, Widerhaken, Schneidmesser oder ein ähnliches Werkzeug verwendet werden.

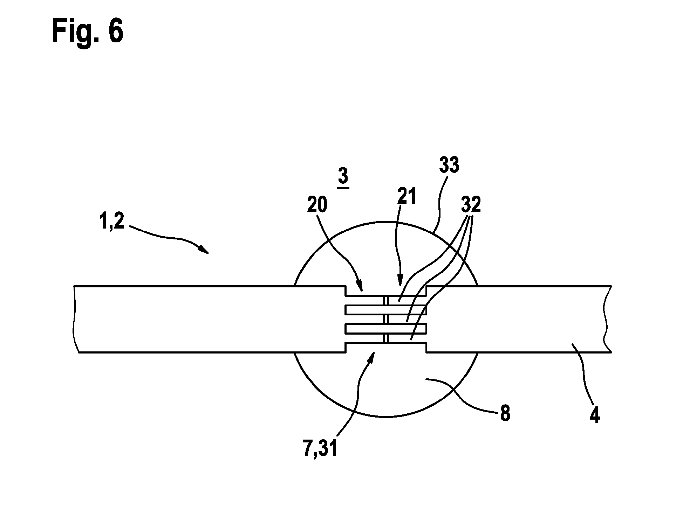

Die Figur 6 zeigt in einer Draufsicht die elektrische Schaltung 1. Die Trennstelle 7 ist hierbei als Sollbruchstelle 31 ausgebildet, die das Auftrennen des Stanzgitters erleichtert. In dem vorliegenden Ausführungsbeispiel ist die Sollbruchstelle 31 durch mehrere schmale Verbindungsstege 32, die jeweils eine Sollbruchstelle aufweisen, ausgebildet. Durch das Vorsehen der schmalen Verbindungsstege 32 werden die auf die Klebeschicht beim Auftrennvorgang auftretenden Kräfte minimiert. Die Verbindungsstege 32 liegen - von oben betrachtet - innerhalb der Ausnehmung 8 und reichen nicht bis an den Rand 33 der Ausnehmung 8, sodass beim Trennvorgang die Trennstellenabschnitte 20, 21 (beziehungsweise 10) bildenden Verbindungsstege 32 nicht gegen den Schaltungsträge 3 gedrückt werden. Vorteilhafterweise werden die Verbindungsstege 32 nacheinander zertrennt, um die auftretenden Trenn-Kräfte zu minimieren. Da die Verbindungsstege 32 nicht bis an den Rand 33 der Ausnehmung 8 reichen, kann die Isolationsschicht 6 nicht durch den Rand 33 der Ausnehmung 8 beschädigt werden. Hierbei kann es vorteilhaft sein, einen Niederhalter für das Stanzgitter 4 zu verwenden, der das Stanzgitter 4 beim Auftrennvorgang auf den Schaltungsträger 3 drückt. Alternativ oder zusätzlich zu der Isolationsschicht 6 ist es denkbar, eine Kunststoffhülse in der Ausnehmung 8 anzuordnen, um einen elektrischen Kontakt zu verhindern. Das in den Ausführungsbeispielen beschriebene Auftrennen des Stanzgitters 4 kann im aufgeklebten Zustand des Stanzgitters 4 vor und/oder nach einer Bestückung des Stanzgitters 4 mit Bauteilen beispielsweise einer Leistungselektronik erfolgen. Ebenfalls kann das Auftrennen vor oder nach dem Aushärten des Klebstoffes der Klebstofffolie 5 erfolgen. Die zum Aufkleben notwendige Kraft kann auch über die Bauteile selbst erfolgen. Zum Bestücken des Stanzgitters mit den Bauteilen kann neben Kleben oder Löten auch ein elektrisch leitfähiges Kleben oder ein Niedertemperatursintern angewandt werden. Eine Kupferlegierung des Stanzgitters 4 ist in seiner Härte so zu wählen, dass sich das Stanzgitter 4 wie oben beschrieben auftrennen lässt.

Durch die vorteilhafte elektrische Schaltung 1 ist es nunmehr möglich, das Stanzgitter 4 nach dem Anordnen auf dem Schaltungsträger 3 auf einfache und kostengünstige Art und Weise aufzutrennen, sodass es bis dahin als ein Bauelement auf einfache Art und Weise gehandhabt werden kann. Durch das Auftrennen der Trennstelle 7 nach dem Anordnen auf dem Schaltungsträge 3 werden insbesondere die Montage- sowie Herstellungskosten verringert. Auch ist es denkbar, die Trennstelle 7 mittels eines Laser- oder Wasserstrahls aufzutrennen.

## Patentansprüche

1. Elektrische Schaltung, insbesondere Leistungselektronik-Schaltung, mit einem Schaltungsträger und mit mindestens einem darauf angeordneten Stanzgitter, **dadurch gekennzeichnet, dass** das Stanzgitter (4) zu seinem Auftrennen mindestens eine Trennstelle (7) und der Schaltungsträger (3) mindestens eine der Trennstelle (7) zugeordnete Ausnehmung (8) zur Aufnahme und/oder zum Untergreifen mindestens eines Trennstellenabschnitts (10,20,21) des Stanzgitters (4) aufweist.

2. Schaltung nach Anspruch 1, **dadurch gekennzeichnet, dass** die Ausnehmung (8) als Aufnahmetasche (9) oder als Durchbruch (18) ausgebildet ist.

3. Schaltung nach einem der vorhergehenden Ansprüche, **dadurch gekennzeichnet, dass** die Trennstelle (7) als Sollbruchstelle (31), insbesondere als Stanz- und/oder Schneidstelle ausgebildet ist.

4. Schaltung nach einem der vorhergehenden Ansprüche, **dadurch gekennzeichnet, dass** das Stanzgitter (4) mittels Klebstoff und/oder mittels mindestens einer Klebstofffolie (5) auf dem Schaltungsträger (3) befestigt ist.

5. Schaltung nach einem der vorhergehenden Ansprüche, **dadurch gekennzeichnet, dass** die Klebstofffolie (5) und/oder der Klebstoff mindestens eine Isolationsschicht (6) aufweist.

6. Schaltung nach einem der vorhergehenden Ansprüche, **dadurch gekennzeichnet, dass** auf der dem Stanzgitter (4) gegenüberliegenden Seite des Schaltungsträges (3) mindestens ein Auffangmittel (27), insbesondere eine Auffangfolie (28), angeordnet ist.

7. Schaltung nach einem der vorhergehenden Ansprüche, **dadurch gekennzeichnet, dass** das Stanzgitter (4) mit mindestens einem elektrischen/elektronischen Bauteil, insbesondere Leistungsbauteil bestückt ist.

8. Schaltung nach einem der vorhergehenden Ansprüche, **dadurch gekennzeichnet, dass** der Schaltungsträger (3) als Aluminium-Grundplatte (14) ausgebildet ist.

9. Verfahren zur Herstellung einer elektrischen Schaltung, insbesondere Leistungselektronik-Schaltung, insbesondere nach einem oder mehreren der vorhergehenden Ansprüche, mit folgenden Schritten:
- Erstellen eines Schaltungsträgers mit mindestens einer Ausnehmung,
- Anordnen eines Stanzgitters auf dem Schaltungsträger,
- Erstellen mindestens einer Trennstelle in dem Stanzgitter im Bereich der Ausnehmung und
- Untergreifen und/oder Einbringen mindestens eines Trennstellenabschnitts in die Ausnehmung.

10. Verfahren nach Anspruch 9, **dadurch gekennzeichnet, dass** die Trennstelle durch Stanzen und/oder Schneiden aufgetrennt wird.

11. Verfahren nach einem der vorhergehenden Ansprüche, **dadurch gekennzeichnet, dass** die Ausnehmung als Aufnahmetasche oder als Durchbruch ausgebildet wird.

12. Verfahren nach einem der vorhergehenden Ansprüche, **dadurch gekennzeichnet, dass** das Stanzgitter mit einem Klebstoff und/oder mindestens einer Klebstofffolie auf dem Schaltungsträger befestigt wird.

13. Verfahren nach einem der vorhergehenden Ansprüche, **dadurch gekennzeichnet, dass** die Klebstofffolie und/oder der Klebstoff mit einer Isolationsschicht versehen wird.

14. Verfahren nach einem der vorhergehenden Ansprüche, **dadurch gekennzeichnet, dass** das Stanzgitter mit mindestens einem elektrischen/elektronische Bauteil, insbesondere Leistungsbauteil, vor oder nach dem Auftrennen bestückt wird.

15. Verfahren nach einem der vorhergehenden Ansprüche, **dadurch gekennzeichnet, dass** auf der dem Stanzgitter gegenüberliegenden Seite des Schaltungsträgers ein Auffangmittel, insbesondere eine Auffangfolie, angeordnet wird.
